# EUROPÄISCHE PATENTSCHRIFT

(11) **EP 1 807 877 B1**
(45) Veröffentlichungstag und Bekanntmachung des Hinweises auf die Patenterteilung: **16.11.2011**
(21) Anmeldenummer: 05774675.2
(22) Anmeldetag: 24.08.2005
(51) Int. Cl.: H01L 33/50, H01L 33/58, H01L 33/60

(54) **LEUCHTDIODEN-ANORDNUNG MIT FARBKONVERSIONS-MATERIAL**
LIGHT-EMITTING DIODE ARRANGEMENT COMPRISING A COLOR-CONVERTING MATERIAL
ENSEMBLE DIODE ELECTROLUMINESCENTE POURVUE D'UNE MATIERE DE CONVERSION DE COULEUR

(30) Priorität: 03.11.2004 DE 102004053116
(43) Veröffentlichungstag der Anmeldung: 18.07.2007
(73) Patentinhaber: Tridonic Jennersdorf GmbH, 8380 Jennersdorf (AT)
(72) Erfinder: PACHLER, Peter, A-8042 Graz - St. Peter (AT)
(74) Vertreter: Rupp, Christian
(86) Internationale Anmeldenummer: PCT/EP2005/009141
(87) Internationale Veröffentlichungsnummer: WO 2006/048064

(56) Entgegenhaltungen:
- EP-A- 1 411 557
- WO-A-00/38250
- WO-A-01/82385
- DE-A1- 2 260 285
- US-A1- 2003 002 272
- US-A1- 2003 141 563
- PATENT ABSTRACTS OF JAPAN Bd. 1998, Nr. 09, 31. Juli 1998 (1998-07-31) & JP 10 107325 A (NICHIA CHEM IND LTD), 24. April 1998 (1998-04-24)

## Beschreibung

Die vorliegende Erfindung bezieht sich auf eine Leuchtdioden-Anordnung gemäß dem Oberbegriff des Anspruchs 1, welche einen Leuchtdioden-Chip aufweist, der von einem Farbkonversions-Material umgeben ist, das dazu genutzt wird, zumindest einen Teil des von dem Leuchtdioden-Chip abgegebenen Lichts in Licht einer anderen Wellenlänge umzusetzen.

Den Hintergrund der vorliegenden Erfindung bildet das Gebiet der Leuchtdioden und insbesondere das Gebiet der sogenannten weißen LEDs". Da lichtemittierende Halbleiterelemente in der Regel Licht in einer spezifischen Wellenlänge aussenden, ist die Erzeugung eines Halbleiterelements, welches unmittelbar weißes Licht abgibt, bislang noch nicht gelungen. Stattdessen sind die Halbleiterelemente derart ausgestaltet, dass sie Licht einer einzelnen Wellenlänge, beispielsweise in den Farben grün, rot oder blau emittieren. Um dennoch die Erzeugung von weißem Licht zu ermöglichen, ist es aus dem Stand der Technik bekannt, das Licht blauer LEDs mittels Farbkonversion in weißes Mischlicht umzusetzen. Hierbei wird ein Phosphor, das üblicherweise in eine Matrix eingebettet ist, um das Halbleiterelement - den sogenannten LED-Die - angeordnet. Das blaue Licht wird nunmehr in der Umgebung des LED-Dies durch die Phosphore absorbiert und nachfolgend in langwelligeres Licht umgesetzt. Dieses längerwellige Licht der Phosphore in Kombination mit dem nicht umgesetzten blauen Licht des Leuchtdioden-Chips resultiert dann in einem weißen Mischlicht.

Die aus dem Stand der Technik bekannten Formen zur Anordnung des Farbkonversions-Materials um den LED-Die herum weisen allerdings meist den Mangel auf, dass das Licht, welches aus dem den LED-Chip umgebenen Farbkonversions-Material austritt, nicht homogen weiß ist, sondern entweder nach räumlicher Richtung eine unterschiedliche Farbe hat und/oder an der Oberfläche der Phosphorschicht eine unterschiedliche Färbung aufweist. Dies führt bei einer Bündelung und Abbildung des emittierten Lichts - beispielsweise mit Hilfe einer Linse - zu einer Verstärkung der Farbinhomogenitäten.

Die Ursache für diese Inhomogenitäten liegt darin, dass der farbkonvertierte Anteil proportional zum Weg des Lichtes durch die Phosphor/Matrix-Umgebung zunimmt. Aufgrund der Tatsache, dass der Leuchtdioden-Chip, der üblicherweise würfel- oder quaderförmig ausgestaltet ist, in alle Richtungen Licht imitiert, ist es sehr schwierig, eine gleichmäßige Umsetzung des Lichts zu realisieren. Hieraus resultiert nun allerdings ein erheblicher Nachteil für eine nachbildende Optik, die homogen weißes Licht aus einer inhomogen lichtemittierenden Fläche realisieren soll. Typischerweise weisen weiße LEDs mit konventionellen Optiken daher eine inhomogene weiße Emission auf, deren Abbildung im Zentrum bläulich und an den Seitenrändern gelblich gefärbt ist.

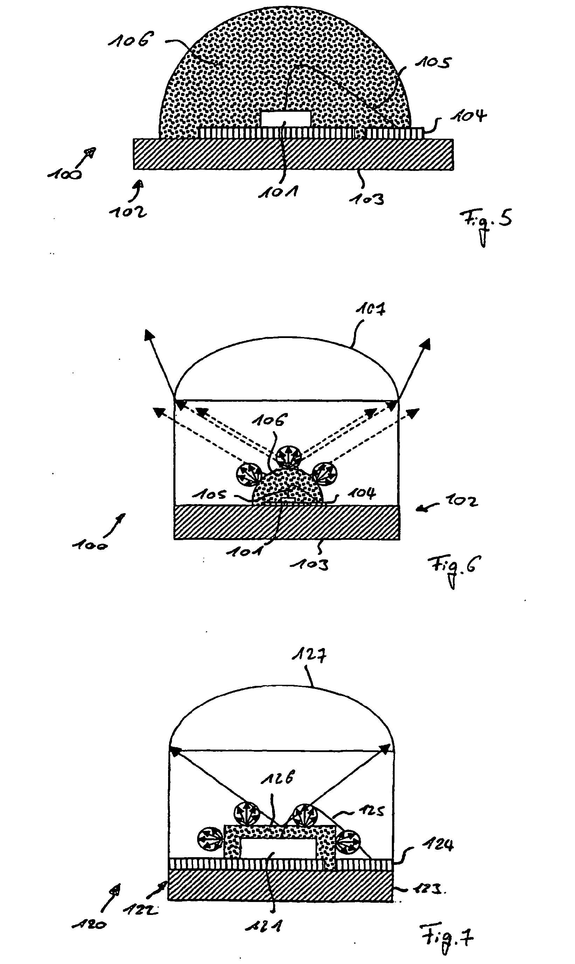

Aus dem Stand der Technik sind verschiedene Anordnungen bekannt, mit denen versucht wird, das von einem Leuchtdioden-Chip emittierte Licht möglichst homogen in ein weißes Mischlicht umzusetzen. Zwei bekannte Ausführungsformen sind in den Figuren 5 bis 7 dargestellt und sollen nachfolgend kurz besprochen werden.

Die erste bekannte Leuchtdioden-Anordnung 100 in den Fig. 5 und 6 weist zunächst einen Leuchtdioden-Chip 101 auf, der auf einer Basis 102 angeordnet ist. Die Basis 102 besteht beispielsweise aus einer thermisch leitfähigen Isolierschicht 103, an deren Oberseite sich eine elektrisch leitfähige Schicht mit Leiterbahnen 104 befindet, auf der wiederum der LED-Die 101 angeordnet ist. Die elektrische Kontaktierung des LED-Dies 101 erfolgt seitlich von den Leiterbahnen 104 her mittels Bonddrähten 105, die zur Oberseite des Leuchtdioden-Chips 101 führen.

Um das von dem Leuchtdioden-Chip 101 emittierte Licht farblich umzusetzen, ist dieser mit einer halbkugel-förmigen Verkapselung umgeben, die vollständig mit einem Farbkonversions-Material 106 ausgefüllt ist. Bei dieser Anordnung wird versucht, durch den annähernd gleichlangen Weg der Lichtstrahlen durch die halbkugel-förmige Verkapselung eine gleichmäßige Oberflächenfarbe zu erzielen. Der Austritt des Lichts mit einem Brechzahlübergang von n ≈ 1,4 bis 1,6 für die Verkapselung gegenüber Luft mit n = 1 sorgt entsprechend der Darstellung in Fig. 6 für eine lokale Vergleichsmäßigung der Teilabstrahlung des nicht umgesetzten blauen Lichts und des durch die Phosphore des Farbkonversions-Materials 106 farbkonvertierten Lichts. Hierdurch wird das resultierende Mischlicht hinsichtlich seiner Farbe homogenisiert.

Die bekannte Konstruktion erfordert allerdings, dass der Leuchtdioden-Chip 101 im Wesentlichen als Punkt angesehen werden kann und somit die Verkapselung wesentlich größer sein muss als die lichtemittierende Fläche am Leuchtdioden-Chip 101. Dies wiederum bringt den Nachteil mit sich, dass für eine Abbildung eines solchen Systems eine sehr große Linse benötigt wird, da für eine effektive Lichtlenkung auch für die Linse die leuchtende Oberfläche als ein angenäherter Punkt wirken sollte. Die Größe der minimal verwendbaren Halbkugel für die Farbkonversion beträgt dementsprechend in etwa das drei- bis vierfache der Kantenlänge des Leuchtdioden-Chips 101, während hingegen die Größe der Linse in etwa das zehn- bis zwanzigfache der leuchtenden Oberfläche betragen sollte.

Fig. 6 zeigt eine vollständige Anordnung für eine Weißlicht-LED, bei der eine Kugelförmige Konvertergeometrie und eine die Anordnung einschließende Linse 107 eingesetzt wird. Da für die Abbildung des Lichts nur ein begrenzter Winkelbereich der Emission genutzt werden kann, ist im Falle eines halbkugelförmigen Konverters mit hohen seitlichen Lichtverlusten zu rechnen, d.h., ein bestimmter Anteil des Lichts kann aufgrund der Emissionscharakteristik nicht durch die Linse 107 abgebildet werden.

Wird hingegen anstelle eines in Form einer Halbkugel ausgestalteten Lichtkonversions-Materials eine Beschichtung mit konstanter Dicke verwendet, so ergibt sich die in Fig. 7 dargestellte Anordnung.

Diese zweite Variante einer bekannten Leuchtdioden-Anordnung 120 besteht zunächst wiederum aus einem Leuchtdioden-Chip 121, der auf einer Basis 122 bestehend aus einer Isolationsschicht 123 und einer Schicht mit Leiterbahnen 124 angeordnet ist. Wie bei der ersten bekannten Anordnung erfolgt auch hier die Kontaktierung mittels eines Bonddrahts 125, der zur Oberseite des Leuchtdioden-Chips 121 geführt ist.

Das Farbkonversions-Material 126 ist nunmehr derart angeordnet, dass es die Oberfläche des Leuchtdioden-Chips 121 allseitig und gleichmäßig mit einer konstanten Dicke bedeckt. Die das Farbkonversions-Material 126 verlassenden Lichtstrahlen werden anschließend wiederum durch eine Linse 127 gebündelt.

Wird die Beschichtung zu dünn gewählt, so ist die Elektrodenstruktur des LED-Chips 121 noch sichtbar, was bei einer Abbildung mit kleinem Abstrahlwinkel (z.B. kleiner als 10°) zu einer ungleichmäßigen Abbildung im Auflichtfeld führt. Auch kann die Elektrodenstruktur zu Farbungleichmäßigkeiten führen, wenn die Schicht des Farbkonversionsmaterials 126 sehr dünn ist. Dies ist beispielsweise dann der Fall, wenn größere Bereiche des Chips 121 nicht leuchten.

Wenn die Schicht hingegen eine höhere Schichtdicke aufweist, besteht die Gefahr, dass der Rand der Schicht in einer anderen Farbe abstrahlt. Allerdings würde dann zumindest die Elektrodenstruktur nicht mehr sichtbar sein und die Farbinhomogenitäten aufgrund größerer, nicht leuchtender Elektrodenstrukturen könnten ebenfalls vermieden werden.

Bei dieser bekannten Anordnung können die von den Seitenflächen emittierten Lichtstrahlen somit nur teilweise für die Abbildung genutzt werden. Mit zunehmender Schichtdicke wird immer mehr Licht durch die Seitenflächen emittiert, wodurch der Anteil an nutzbarem Licht immer weiter reduziert wird. Auch diese bekannte Ausgestaltung weist somit Nachteile im Hinblick auf die erzielbare homogene weiße Lichtabstrahlung und die Möglichkeit der Abbildung dieser mittels einer Optik auf.

Zwischen den in den Figuren 5 bis 7 dargestellten bekannten Ausführungsformen für Leuchtdioden-Anordnungen gibt es sehr viele Zwischengeometrien, welche allerdings nicht realisiert werden, da im Wesentlichen lediglich die Bauhöhe für die in Fig. 6 dargestellte Leuchtdioden-Anordnung eine akzeptable Größe besitzt.

Eine Möglichkeit, weißes Licht ohne den Einsatz eines Farbkonversions-Materials zu erzeugen, ist in der WO 02/50472 A1 beschrieben. Diese Veröffentlichung beschreibt eine Leuchtdioden-Anordnung, bei der an der Bodenseite eines trichterförmigen Reflektors mehrere Leuchtdioden-Chips unterschiedlicher Farben angeordnet sind. Durch die Anordnung der verschiedenfarbigen Leuchtdioden-Chips sowie eine besondere Ausgestaltung des Reflektors wird ereicht, dass sich das Licht der Leuchtdioden-Chips insgesamt zu weißem Licht vermischt. Allerdings ist diese bekannte Konstruktion im Vergleich zu den in den Fig. 5 bis 7 dargestellten Lösungen, bei denen jeweils einzelne Leuchtdioden-Chips verwendet werden können, sehr aufwendig.

Dokument JP 10-107325 A zeigt einen LED-Chip, welcher in einem Aufnahmeteil aufgenommen ist und mit Farbkonversions-Material umgeben ist. Das Dokument zeigt ferner eine schräg zur Abstrahlfläche und oberhalb dieser angeordnete, reflektierende Fläche bzw. Ebene, die sich von der Oberseite des Aufnahmeteils weg erstreckt.

Dokument EP 1 411 557 A2 zeigt eine LED mit einem Wellenlängen-Konversionselement für den Fahrzeuggebrauch. Ein LED-Chip ist hierzu in einer Basis angeordnet. Eine Kraftfahrzeug-Lampenanordnung weist gemäß einem Ausführungsbeispiel der vorgenannten Druckschrift sechzehn der LED-Chips auf, die mit einem Reflektor derart angeordnet sind, dass das von ihnen abgestrahlte Licht derart gebündelt wird, dass es nach vorne abgestrahlt wird.

Der vorliegenden Erfindung liegt dementsprechend die Aufgabe zugrunde, eine Möglichkeit zur Realisierung einer Leuchtdioden-Anordnung anzugeben, bei der das von einem Leuchtdioden-Chip abgegebene Licht mittels einem Farbkonversions- Material zur Erzeugung von Mischlicht umgesetzt wird und bei der die im Zusammenhang mit dem Stand der Technik beschriebene Nachteile vermieden werden. Insbesondere soll eine weißes Licht emittierende Oberfläche erzeugt werden, die mittels konventioneller Optiken homogen und ohne Farbabweichungen abgebildet werden kann.

Die Aufgabe wird durch eine Leuchtdioden-Anordnung, welche die Merkmale des Anspruchs 1 aufweist, gelöst. Vorteilhafte Weiterbildungen der Erfindung sind Gegenstand der Unteransprüche.

Es wird also eine Leuchtdioden-Anordnung vorgeschlagen, welche einen auf einer Basis angeordneten Leuchtdioden-Chip sowie ein den Leuchtdioden-Chip obenauf überdeckendes und seitlich umgebenes Farbkonversions-Material aufweist, welches dazu ausgebildet ist, zumindest einen Teil des von dem Leuchtdioden-Chip abgegebenen Lichts in Licht einer anderen Wellenlänge umzusetzen. Das den Leuchtdioden-Chip seitlich umgebende Farbkonversions-Material ist seitlich von einem Reflektor umgeben, wobei der seitliche Abstand von dem Leuchtdioden-Chip zu dem Reflektor im Bereich zwischen 0,1 mm und 0,2 mm Wegt. Erfindungsgemäß weist die Leuchtdioden-Anordnung ferner auf: eine Optik zum Bündeln des von dem Leuchtdioden-Chip abgegebenen Lichts, wobei die Optik durch eine Linse gebildet wird, welche - in Abstrahlrichtung gesehen - vor dem Leuchtdioden-Chip angeordnet ist, und wobei die Linse von der Oberfläche des Farbkonversions-Materials durch einen Luftspalt getrennt angeordnet ist

Gemäß der vorliegenden Erfindung wird also zur Vermeidung der bekannten Farbinhomogenitäten das Farbkonversions-Material seitlich durch einen - vorzugsweise vertikal angeordneten - Reflektor begrenzt. Zwar ist es bereits bekannt, LED-Chips mit einem Reflektor bzw. reflektierenden Elementen zu umgeben, in den bekannten Fällen ist der Abstand zwischen dem Leuchtdioden-Chip und dem Reflektor allerdings deutlich größer als dies gemäß der vorliegenden Erfindung vorgesehen ist. Die Ursache hierfür liegt darin, dass beim Stand der Technik die reflektierenden Elemente ausschließlich dazu vorgesehen sind, das von dem Leuchtdioden-Chip abgegebene Licht bereits in eine bestimmte Richtung zu bündeln. Die primäre Aufgabe des Reflektors gemäß der vorliegenden Erfindung hingegen besteht darin, den Verlauf des Lichts durch das Farbkonversions-Material zum Erzielen einer homogenen Mischlichtabgabe zu optimieren.

So wird durch den Reflektor zunächst eine seitliche Emission von Licht ausgeschlossen, welches lediglich zum Teil durch eine brechende Linse genutzt, also abgebildet werden könnte. Auf der anderen Seite erlaubt die Verwendung des Reflektors eine größere Schichtdicke für das Farbkonversions-Matenial oberhalb des Leuchtdioden-Chips. Diese größere Schichtdicke wiederum führt zu einer besseren Farbdurchmischung des Lichts, so dass etwaige Elektrodenstrukturen des Leuchtdioden-Chips nicht mehr durch das Farbkonversions-Material durchscheinen. Ein weiterer Vorteil besteht auch darin, dass mit Hilfe des Reflektors die Größe der abzubildenden Fläche möglichst klein gehalten wird, wodurch sich die Baugröße der verwendeten Optik bzw. Linse ebenfalls in Grenzen hält.

Erfindungsgemäß ist die Linse von der Oberfläche des Farbkonversions-Materials über einen Luftspalt getrennt angeordnet. Wie später noch näher erläutert wird, wird durch diese spezielle Ausgestaltung eine besonders gute Durchmischung und damit eine farblich homogene Lichtabstrahlung erzielt.

Vorzugsweise beträgt die Dicke des die Oberseite des Leuchtdioden-Chips überdeckenden Farbkonversions-Materials mindestens 0,05 mm, wobei insbesondere vorgesehen ist, dass die Dicke um mindestens 0,05 mm größer ist als der Abstand zwischen dem Leuchtdioden-Chip und dem Reflektor.

Der das Farbkonversions-Matexial vorzugsweise über seine gesamte Höhe hinweg umschließende Reflektor kann zum einen aus Metall bestehen, es wäre allerdings auch denkbar, den Reflektor diffus reflektierend auszubilden, wozu beispielsweise Teflon oder ein anderes geeignete Material verwendet werden könnte.

Nachfolgend soll die Ereindung anhand der beiliegenden Zeichnungen naher erläutert werden. Es zeigen:
- Fig. 1: eine Leuchtdioden-Anordnung;
- Fig. 2: ein Schema zur Erläuterung der geometrischen Abmessungen des zur Farbumsetzung verwendeten Farbkonversions-Materials;
- Fig. 3: eine weitere Leuchtdioden-Anordnung;
- Fig. 4a u. 4b: ein Ausfilhrungsbeispiel einer erfindungsgemäßen Leuchtdioden-Anordnung, und
- Fig. 5-7: Leuchtdioden-Anordnungen gemäß dem Stand der Technik.

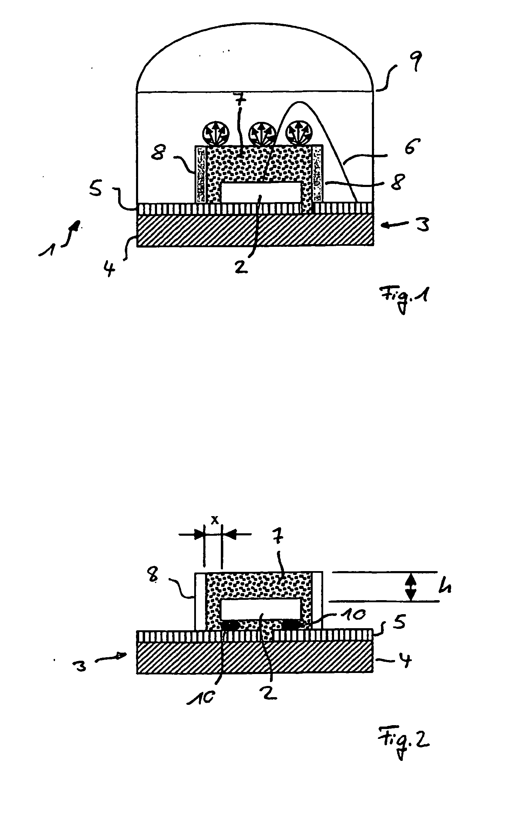

Die in Fig. 1 dargestellte und mit dem Bezugszeichen 1 versehene Leuchtdioden-Anordnung weist zunächst wiederum einen - vorzugsweise blaues Licht emittierenden - Leuchtdioden-Chip 2 auf, der auf einer Basis 3 angeordnet ist, die eine Isolationsschicht 4 sowie eine elektrisch leitfähige Schicht mit Leiterbahnen 5 aufweist, wobei von diesen Leiterbahnen Bonddrähte 6 zur Kontaktierung des Leuchtdioden-Chips 2 zu dessen Oberseite hin führt. Anzumerken ist, das die Basis 3 auch in anderer Weise ausgestaltet sein könnte. Insbesondere könnten spezielle Maßnahmen getroffen werden, welche eine effektive Wärmeableitung von dem Leuchtdioden-Chip 2 ermöglichen.

Um das von dem Leuchtdioden-Chip 2 emittierte Licht in weißes Mischlicht umzusetzen, ist ein Farbkonversions-Material 7 vorgesehen, welches den Leuchtdioden-Chip 2 umgibt und Farbkonversions-Teilchen, insbesondere Phosphore aufweist, die zumindest einen Teil des Lichts in ein Licht anderer Wellenlänge umsetzen. Der Leuchtdioden-Chip 2 und das Farbkonversions-Material 7 sind von einer reflektierenden Wand 8 umgeben, welche beispielsweise durch einen metallischen Reflektor gebildet oder aber auch diffus reflektierend ausgestaltet sein kann und hierzu beispielsweise aus Teflon oder z.B. Bariumsulfat besteht. Im Gegensatz zu bekannten Leuchtdioden-Anordnungen ist die reflektierende Wand 8 bereits in einher Entfernung von 0,1 mm bis 0,2 mm von den Seitenflächen des Leuchtdioden-Chips 2 angebracht.

Durch die - vorzugsweise vertikal ausgerichtete - reflektierende Wandung 8 wird von dem Leuchtdioden-Chip 2 seitlich ausgestrahltes Licht wieder umgelenkt und damit zunächst die Größe der lichtemittierenden Fläche auf die obere Öffnung des Reflektors 8 beschränkt. Ferner wird Licht, welches seitlich aus dem Leuchtdioden-Chip 2 austritt, in dem umgebenden Farbkonversions-Material 7 zum Teil umgewandelt bzw. es wird jener Anteil, der beim erstmaligen Durchgang durch die Phosphor-Teilchen nicht absorbiert und umgesetzt wurde, an der Reflexionswand 8 reflektiert wird und nachfolgend wieder zurückgeleitet, bis auch dieses Licht eine weiße spektrale Verteilung aufweist und an der Oberseite des Farbkonversions-Materials 7 austritt.

Die Anordnung bestehend aus dem LED-Chip 2, dem Farbkonversions-Material 7 und dem Reflektor 8 ist schließlich noch von einer Optik umgeben, die durch eine Linse 9 gebildet wird, welche die Anordnung umschließt. Die Linse 9 ist derart ausgestaltet, dass sie lediglich in ihrem oberen Bereich eine gekrümmte Oberfläche aufweist, um das an der Oberseite des Farbkonversions-Materials 7 austretende Licht in gewünschter Weise abzubilden. Der untere zylinderförmige Bereich der Linse hingegen besitzt keine optische Funktion, da aufgrund der Eingrenzung des lichtemittierenden Bereichs mit Hilfe des Reflektors 8 in diesen Bereichen ohnehin kein Licht austritt. Der Reflektor 8 gestattet es somit, eine sehr einfach und kompakt ausgestaltete Linse einzusetzen, welche trotz allem das von dem Leuchtdioden-Chip emittierte und ggf. durch das Farbkonversions-Material 7 umgesetzte Licht vollständig abbildet Seitlich austretendes Licht hingegen, welches eine nicht gewünschte Farbmischung aufweist und demzufolge nicht genutzt werden könnte, liegt bei der Leuchtdioden-Anordnung nicht vor.

Die besonderen Abmessungen der Leuchtdioden-Anordnung 1 sind nochmals in Fig. 2 verdeutlicht. Wie dieser Darstellung entnommen werden kann, ist der Abstand zwischen der Seitenfläche des Leuchtdioden-Chips 2 und dem Reflektor 8 mit x bezeichnet, während hingegen der Abstand von der Oberfläche des Leuchtdioden-Chips 2 zur Oberfläche des Farbkonversions-Materials 7 mit h bezeichnet ist. Wie bereits erwähnt wurde, ist der Abstand x zwischen dem Leuchtdioden-Chip und dem Reflektor 8 sehr klein gewählt und beträgt 0,1 mm bis 0,2 mm. Die Höhe h der Farbkonversions-Schicht 7 hingegen beträgt mindestens 0,05 mm und wird vorzugsweise derart gewählt, dass für die minimale Höhe gilt hₘᵢₙ = 0,05 mm + x. Eine obere Begrenzung für die Höhe h der Farbkonversions-Schicht besteht im Prinzip nicht, da die Erzeugung des Mischlichts optimiert wird, je größer die Höhe ist. Wie bereits eingangs erwähnt wurde, ist die Wahrscheinlichkeit für die Umsetzung des von dem Leuchtdioden-Chip 2 abgegebenen Lichts proportional zur Weglänge des Lichts durch das Farbkonversions-Material 7, weshalb zum Erzielen einer homogenen Lichtabgabe eine möglichst große Dicke angestrebt werden sollte. Aus fertigungstechnischen Gründen jedoch wird bevorzugt eine Obergrenze für die Dicke h von 3 mm gewählt, da insgesamt gesehen auch eine möglichst kompakte und flache Ausgestaltung der Leuchtdioden-Anordnung angestrebt wird.

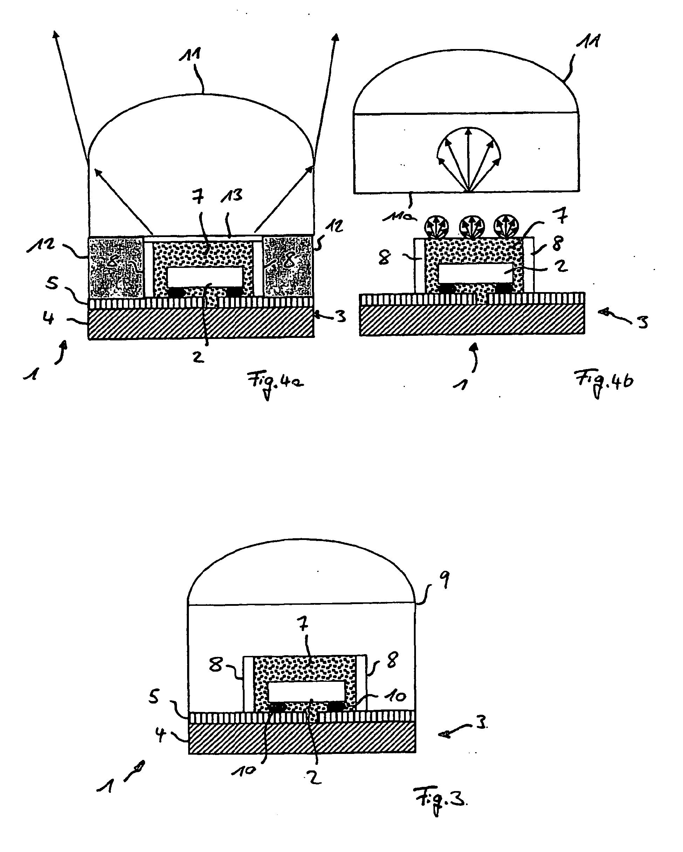

Ein Unterschied zu der in Fig. 1 dargestellten Leuchtdioden-Anordnung besteht bei der Anordnung in Fig. 2 darin, dass nunmehr die elektrische Kontaktierung des Leuchtdioden-Chips 2 nicht mehr über Bonddrähte erfolgt. Stattdessen ist der Chip 2 in der dargestellten Ausführungsform "face down", also verkehrt angeordnet Die Kontaktierung erfolgt in einem derartigen Fall mittels sogenannter Bumps 10, welche unmittelbar eine Kontaktierung von der Schicht mit den Leiterbahnen 5 zur Oberfläche des Chips 2 herstellen. Diese oftmals auch als Flip-Chip-Technologie bezeichnete Anordnung des Leuchtdioden-Chips 2 auf der Basis 3 bringt u.a, auch Vorteile im Hinblick auf die erzielbare Lichtstärke mit sich, da bei dieser Montagetechnik eine verbesserte Lichtabgabe erzielt werden kann. Dies ist unter anderem darauf zurückzuführen, dass keine Bonddrähte erforderlich sind und damit eine schattenfreie Abstrahlfläche erhalten wird. Eine vollständige Anordnung einer Leuchtdioden-Anordnung, bei der dann der Reflektor 8 mit dem Farbkonversions-Material 7 und dem Leuchtdioden-Chip 2 wiederum von einer Linsenanordnung 9 umgeben ist, ist in Fig. 3 dargestellt.

Bei den beiden zuvor besprochenen Ausführungsbeispielen wurden das Farbkonversions-Material 7 und der Reflektor 8 unmittelbar von der die Linse 9 bildenden Optik eingeschlossen. Die Figuren 4a und 4b zeigen nunmehr ein Ausführungsbeispiel einer erfindungsgemäßen Leuchtdioden-Anordnung 1, bei der eine sogenannte Vorsatzlinse 11 zum Einsatz kommt, die mit Distanz zu der Oberfläche, des Farbkonversions-Materials 7 angeordnet ist Die Leuchtdioden-Anordnung 1 weist zunächst wiederum die gleichen Elemente wie das Ausführungsbeispiel von Fig. 3 auf, wobei gleiche Komponenten mit den gleichen Bezugszeichen versehen sind. Zusätzlich sind nunmehr allerdings auf der Oberfläche der elektrisch leitfähigen Schicht mit den Leiterbahnen 5 Abstandhalter 12 angeordnet, an deren Oberseite die Vorsatzlinse 11 angeordnet ist. Die Höhe der Abstandhalter 12, die beispielsweise durch eine weitere Isolationsschicht gebildet sein könnten, ist derart gewählt, dass die Vorsatzlinse 11 über einen kleinen Luftspalt 13 von dem Farbkonversions-Material 7 getrennt ist. Hierdurch wird eine besonders effiziente Abbildung des von der Oberseite des Farbkonversions-Materials 7 ausgehenden Lichts ermöglicht

Das Licht nämlich, dass durch die Oberfläche des Farbkonversions-Materials 7 austritt, wird nunmehr über den Luftspalt 13 in die Vorsatzlinse 11 eingekoppelt. Beim Austritt aus dem Farbkonversions-Material 7 ist das Licht aufgrund der Steuerung durch das Phosphormaterial und des Brechzahlübergangs von dem Phosphormatrixmaterial auf Luft lambersch verteilt, d.h. die Lichtabgabe ist in alle Richtungen hin gesehen im wesentlichen gleich groß. Diese Verteilung wiederum wird beim Eintritt in die Vorsatzlinse 11 entsprechend der Brechzahl der Linse auf einen Bereich von beispielsweise ± 41,8° gebündelt, für den Fall, dass die Brechzahl der Vorsatzlinse 11 n = 1 ,5 beträgt. Dieser Effekt ist in Fig. 4b dargestellt. Beim Austritt aus der Linse 11 müssen die Lichtstrahlen dann z,B. für eine 40°-Linse nunmehr maximal um 21,8° umgelenkt werden, was ohne größeren Aufwand realisiert und insbesondere ohne größere Verluste durchgerührt werden kann.

Der dargestellte Aufbau mit dem durch einen Reflektor seitlich begrenzten Farbkonversions-Material bietet somit die Möglichkeit, Licht - mit Ausnahme der Fresnelreflexionen - zu nahezu 100% abzubilden. Im Vergleich zum Stand der Technik kann damit der Nutzlichtanteil innerhalb eines gewünschten Zielbereichs wesentlich erhöht werden. Gleichzeitig wird eine effektivere Farbdurchmischung erzielt, durch die sichergestellt ist, dass auch mittels einer Linse oder einer anderweitigen konventionellen Optik weißes Mischlicht in effektiver Weise homogen abgebildet werden kann.

## Patentansprüche

1. Leuchtdioden-Anordnung, aufweisend:
einen auf einer Basis (3) angeordneten Leuchtdioden-Chip (2) sowie den Leuchtdioden-Chip (2) obenauf überdeckendes und seitlich umgebendes Farbkonversionsmaterial (7), welches dazu ausgebildet ist, zumindest einen Teil des von dem Leuchtdioden Chip (2) abgegebenen Lichts in Licht einer anderen Wellenlänge umzusetzen,
wobei das den Leuchtdiodeng-Chip (2) seitlich umgebende Farbkonversions-Material (7) seitlich von einem Reflektor (8) umgeben ist, wobei der seitliche Abstand (x) von dem Leuchtdioden-Chip (2) zu dem Reflektor (8) im Bereich zwischen 0,1 mm und 0,2 mm liegt,
wobei die Leuchtdioden-Anordnung eine linse (11) zum Bündeln des von dem Leuchtdioden-Chip (2) abgegebenen Lichts, aufweist,
welche - in Abstrahlrichtung gesehen - vor dem Leuchtdioden-Chip (2) angeordnet ist, **dadurch gekennzeichnet, dass** die Linse (11) von der Oberfläche des Farbkonversions-Msterials (7) durch einen Luftspalt (13) getrennt angeordnet ist.

2. Leuchtdioden Anordnung nach Anspruch 1,
**dadurch gekennzeichnet,**
**dass** der Reflektor (8) das Farbkonversions-Material (7) über seine gesamt Höhe hinweg umschließt.

3. Leuchtdioden-Anordnung nach einem der vorherigen Ansprüche,
**dadurch gekennzeichnet,**
**dass** der Reflektor (8) vertikal ausgerichtet ist

4. Leuchtdioden-Anordnung nach einem der vorherigen Ansprüche,
**dadurch gekewazeichnet,**
**dass** die Dicke (h) des die Oberseite des Leuchtdoden-Chips (2) überdeckenden Farbkonversions-Materials (7) mindestens 0,05 mm beträgt.

5. Leuchtdioden-Anordnung nach Anspruch 4,
**dadurch gekennzeichnet,**
**dass** die Dicke (h) des die Oberseite des Leuchtdioden-Chips (2) überdeckenden Farbkonversions-Materials (7) um mindestens 0,05 mm größer ist als der Abstand (x) zwischen dem Leuchtdioden-Chip (2) und dem Reflektor (8).

6. Leuchtdioden-Anordnung nach Anspruch 4 oder 5,
**dadurch gekennzeichnet,**
**dass** die Dicke (h) des die Oberseite des Leuchtdioden-Chips (2) überdeckenden Farbkonversions-Materials (7) maximal 3 mm beträgt.

7. Leuchtdioden-Anordnung nach einem der vorherigen Ansprüche,
**dadurch gekennzeichnet,**
**dass** der Reflektor (8) aus Metall besteht.

8. Leuchtdioden-Anordnung nach einem der Ansprüche 1 bis 6,
**dadurch gekennzeichnet,**
**dass** der Reflektor (8) diffus reflektierend ausgebildet ist.

9. Leuchtdioden-Anordnung nach Anspruch 8,
**dadurch gekennzeichnet,**
**dass** der Reftektor (8) aus Teflon besteht.

10. Leuchtdioden-Anordnung nach einem der vorhergehenden Ansprüche,
**dadurch gekennzeichnet,**
**dass** auf der Oberfläche der Basis (3) Abstandhalter (12) angeordnet sind, an deren Oberseite die Linse (11) angeordnet ist, wobei die Höhe der Abstandhalter (12) derart gewählt ist, dass die Linse (11) über den Luftspalt (13) von dem Farbkonversations-Material (7) getrennt ist, und
**dass** die Basis (3) eine Isolationsschicht (4) sowie eine elektrisch leitfähige Schicht mit Leiterbahnen (5) aufweist, wobei die Kontaktierung von dieser elektrisch leifähigen Schicht mit den Leiterbahnen (5) zur Oberfläche des des Leuchtdioden-Chips(2) mittels Bumps (10) erfolgt,
wobei die Abstandhalter (12) auf der Oberfläche der elektrisch leitfähigen Schicht mit den Leiterbahnen (5) angeordnet sind.

## Claims

1. Light-emitting diode arrangement, comprising:
a light-emitting diode chip (2) arranged on a base (3), and colour conversion material (7) covering the light-emitting diode chip (2) on top and laterally surrounding it, said colour conversion material being designed to convert at least part of the light emitted by the light-emitting diode chip (2) into light having a different wavelength,
wherein the colour conversion material (7) laterally surrounding the light-emitting diode (2) is laterally surrounded by a reflector (8), wherein the lateral distance (x) between the light-emitting diode chip (2) and the reflector (8) is in the range of between 0.1 mm and 0.2 mm,
wherein the light-emitting diode arrangement comprises a lens (11) for concentrating the light emitted by the light-emitting diode chip (2), said lens being arranged - as viewed in the emission direction - in front of the light-emitting diode chip (2),
**characterized**
**in that** the lens (11) is arranged in a manner separated from the surface of the colour conversion material (7) by an air gap (13).

2. Light-emitting diode arrangement according to Claim 1,
**characterized**
**in that** the reflector (8) encloses the colour conversion material (7) across its entire height.

3. Light-emitting diode arrangement according to either of the preceding claims,
**characterized**
**in that** the reflector (8) is oriented vertically.

4. Light-emitting diode arrangement according to any of the preceding claims,
**characterized**
**in that** the thickness (h) of the colour conversion material (7) covering the top side of the light-emitting diode chip (2) is at least 0.05 mm.

5. Light-emitting diode arrangement according to Claim 4,
**characterized**
**in that** the thickness (h) of the colour conversion material (7) covering the top side of the light-emitting diode chip (2) is at least 0.05 mm greater than the distance (x) between the light-emitting diode chip (2) and the reflector (8).

6. Light-emitting diode arrangement according to Claim 4 or 5,
**characterized**
**in that** the thickness (h) of the colour conversion material (7) covering the top side of the light-emitting diode chip (2) is at most 3 mm.

7. Light-emitting diode arrangement according to any of the preceding claims,
**characterized**
**in that** the reflector (8) consists of metal.

8. Light-emitting diode arrangement according to any of Claims 1 to 6,
**characterized**
**in that** the reflector (8) is embodied such that it is diffusely reflective.

9. Light-emitting diode arrangement according to Claim 8,
**characterized**
**in that** the reflector (8) consists of Teflon.

10. Light-emitting diode arrangement according to any of the preceding claims,
**characterized**
**in that** spacers (12) are arranged on the surface of the base (3), the lens (11) being arranged at the top side of said spacers, wherein the height of the spacers (12) is chosen in such a way that the lens (11) is separated from the colour conversion material (7) via the air gap (13), and
**in that** the base (3) has an insulation layer (4) and also an electrically conductive layer with conductor tracks (5), wherein said electrically conductive layer with the conductor tracks (5) is contact-connected to the surface of the light-emitting diode chip (2) by means of bumps (10), wherein the spacers (12) are arranged on the surface of the electrically conductive layer with the conductor tracks (5).

## Revendications

1. Ensemble diode électroluminescente présentant :
une puce (2) à diode électroluminescente disposée sur une base (3) ainsi que du matériau (7) de conversion de couleur recouvrant la puce (2) à diode électroluminescente sur le dessus et l'entourant latéralement, le matériel étant conçu pour convertir au moins une partie de la lumière sortie de la puce (2) à diode électroluminescente en lumière d'une autre longueur d'onde,
dans lequel le matériau (7) de conversion de couleur entourant latéralement la puce (2) à diode électroluminescente est entouré latéralement par un réflecteur (8), l'écart latéral (x) depuis la puce (2) à diode électroluminescente jusqu'au réflecteur (8) se trouvant dans le domaine entre 0,1 mm et 0,2 mm,
l'ensemble diode électroluminescente comprenant une lentille (11) pour concentrer la lumière émise par la puce (2) à diode électroluminescente, laquelle lentille étant disposée - par rapport à la direction d'émission - avant la puce (2) à diode électroluminescente, **caractérisé en ce que** la lentille (11) est disposée de façon à être séparée de la surface du matériau (7) de conversion de couleur par un intervalle d'air (13).

2. Ensemble diode électroluminescente selon la revendication 1,
**caractérisé en ce que** le réflecteur (8) entoure le matériau (7) de conversion de couleur sur toute sa hauteur.

3. Ensemble diode électroluminescente selon l'une des revendications précédentes,
**caractérisé en ce que**
le réflecteur (8) est aligné verticalement.

4. Ensemble diode électroluminescente selon l'une des revendications précédentes,
**caractérisé en ce que**
l'épaisseur (h) du matériau (7) de conversion de couleur qui recouvre la partie supérieure de la puce (2) à diode électroluminescente se monte à au moins 0,05 mm.

5. Ensemble diode électroluminescente selon la revendication 4,
**caractérisé en ce que**
l'épaisseur (h) du matériau (7) de conversion de couleur qui recouvre la partie supérieure de la puce (2) à diode électroluminescente est supérieure d'au moins 0,05 mm à l'écart (x) entre la puce (2) à diode électroluminescente et le réflecteur (8).

6. Ensemble diode électroluminescente selon la revendication 4 ou 5,
**caractérisé en ce que**
l'épaisseur (h) du matériau (7) de conversion de couleur qui recouvre la partie supérieure de la puce (2) à diode électroluminescente se monte à 3 mm au maximum.

7. Ensemble diode électroluminescente selon l'une des revendications précédentes,
**caractérisé en ce que**
le réflecteur (8) est constitué de métal.

8. Ensemble diode électroluminescente selon l'une des revendications 1 à 6,
**caractérisé en ce que**
le réflecteur (8) est arrangé pour réfléchir de façon diffuse.

9. Ensemble diode électroluminescente selon la revendication 8,
**caractérisé en ce que**
le réflecteur (8) est en téflon.

10. Ensemble diode électroluminescente selon l'une des revendications précédentes,
**caractérisé en ce que**
des écarteurs (12) sont disposés sur la surface de la base (3), la lentille (11) étant disposée sur leur partie supérieure, la hauteur des écarteurs (12) étant choisie de sorte que la lentille (11) est séparée du matériau (7) de conversion de couleur par l'intervalle d'air (13), et
**en ce que** la base (3) présente une couche d'isolation (4) ainsi qu'une couche électriquement conductrice avec des pistes conductrices (5), le contact entre d'une part cette couche électriquement conductrice avec les pistes conductrices (5) et d'autre part la surface de la puce (2) à diode électroluminescente s'effectuant au moyen de bosses (10), les écarteurs (12) étant disposés sur la surface de la couche électriquement conductrice avec les pistes conductrices (5).
